# EUROPEAN PATENT APPLICATION

(11) **EP 4 644 989 A1**
(43) Date of publication of application: **05.11.2025**
(21) Application number: 23912245.0
(22) Date of filing: 27.12.2023
(51) Int. Cl.: G03F 1/62, C01B 32/174

(54) **PELLICLE FILM, PELLICLE, EXPOSURE ORIGINAL PLATE, AND EXPOSURE DEVICE**

(30) Priority: 27.12.2022 JP 2022209822
(71) Applicant: Mitsui Chemicals, Inc., Tokyo 104-0028 (JP)
(72) Inventor: YANO, Kohei, Nobeoka-shi, Miyazaki 882-0031 (JP); TAKAHASHI, Tenga, Nobeoka-shi, Miyazaki 882-0031 (JP)
(74) Representative: Hoffmann Eitle
(86) International application number: PCT/JP2023/046915
(87) International publication number: WO 2024/143467

(57) **Abstract**

Provided is a pellicle film that is likely to have uniform in-plane thickness and, as a result, is likely to have uniform transmittance with respect to EUV light. A pellicle film 12 is used in EUV lithography. The pellicle film 12 has bundles 21 containing a plurality of carbon nanotubes (CNTs) 23. Here, in the pellicle film 12, when the bundles 21 are cut along a plane intersecting the direction in which the CNTs extend, the included bundles 21 have an oblateness {(t1-t2)/t1} of 0.10-0.90 as calculated from the long diameter (t1) and the short diameter (t2) of the bundles wq.

## Description

### FIELD

The present invention relates to a pellicle film, a pellicle, an exposure original plate and an exposure device.

### BACKGROUND

Semiconductor elements are produced by lithography. In lithography, exposure light emitted from an exposure device is irradiated onto a mask on which a circuit pattern has been drawn, thereby transferring the circuit pattern onto the photoresist. During this time, a pellicle is attached to the mask to prevent dust and contamination from adhering to the mask. The pellicle has a frame and a pellicle film provided in the frame so as to block the opening formed by the frame.

Due to increasing demand for micronization of patterns, EUV (Extreme Ultra Violet) lithography is becoming an area of interest as a next-generation lithography technique. In EUV lithography, the exposure light used is EUV light, which has a shorter wavelength than conventional exposure light (such as ArF excimer laser light). In order to withstand the temperature increase caused by irradiation with EUV light, the pellicle film used for EUV lithography must exhibit high heat resistance.

Pellicle films have been proposed that include carbon nanotubes (hereunder also referred to as "CNT") as a material with excellent heat resistance (see PTL 1). PTL 1 discloses a pellicle film including CNTs with a diameter of 0.8 to 6 nm, a length of 10 µm to 10 cm and a carbon content of 98 mass% or greater.

### [CITATION LIST]

### [PATENT LITERATURE]

[PTL 1] International Patent Publication No. WO2018/008594

### SUMMARY

### [TECHNICAL PROBLEM]

The prior art has been less than fully satisfactory in terms of providing a pellicle film that can easily provide uniform transmittance for EUV light.

It is therefore an object of the present invention to provide a pellicle film that tends to have a uniform in-plane thickness, and that therefore easily exhibits uniform transmittance for EUV light. It is another object of the invention to provide a pellicle, an exposure original plate and an exposure device which have such a pellicle film.

### [SOLUTION TO PROBLEM]

One aspect of the present invention is as follows.
[1] A pellicle film to be used for EUV lithography, wherein:
   the pellicle film has a bundle comprising a plurality of carbon nanotubes (CNT), and
   the pellicle film includes the bundle which has a flatness ratio {(t1 - t2)/t1} of 0.10 to 0.90, calculated from the long diameter (t1) and short diameter (t2) of the bundle, when the bundle has been cut on the plane crossing the CNTs in the direction of extension.
[2] The pellicle film according to [1] above, wherein the bundle comprises an inorganic material layer containing an inorganic oxide and/or an inorganic nitride.
[3] The pellicle film according to [2] above, wherein the pellicle film has the inorganic material layer on the outermost periphery of the bundle.
[4] The pellicle film according to [2] or [3] above, wherein:
   the inorganic material layer surrounds the entire bundle, when the bundle has been cut on the plane crossing the CNTs in the direction of extension.
[5] The pellicle film according to any one of [2] to [4] above,
   which includes the inorganic material layer wherein the thickness of the inorganic material layer is 0.5 to 8.0 nm,
   when the bundle has been cut on the plane crossing the CNT in the direction of extension.
[6] The pellicle film according to any one of [1] to [5] above, wherein:
   the long diameter (t1) of the bundle is 5.0 to 40.0 nm and the short diameter (t2) is 2.0 to 20.0 nm,
   when the bundle has been cut on the plane crossing the CNTs in the direction of extension.
[7] The pellicle film according to any one of [2] to [6] above, wherein the ratio (ni/nc) between the refractive index (ni) of the inorganic material layer at an exposure wavelength of 13.5 nm and the refractive index (nc) of the CNTs at an exposure wavelength of 13.5 nm is 0.95 to 1.05.
[8] The pellicle film according to any one of [2] to [7] above, wherein the extinction coefficient (ki) of the inorganic material layer at an exposure wavelength of 13.5 nm is 0.05 or lower.
[9] The pellicle film according to any one of [2] to [8] above, wherein:
   the inorganic material composing the inorganic material layer
   which includes at least one oxide and/or nitride selected from the group consisting of zirconium (Zr), niobium (Nb), aluminum (Al), hafnium (Hf), lanthanum (La), molybdenum (Mo), silicon (Si), yttrium (Y) and titanium (Ti).
[10] The pellicle film according to any one of [1] to [9] above, wherein the transmittance for EUV light is 90% or greater.
[11] A pellicle comprising:
   a frame, and
   a pellicle film according to any one of [1] to [10] above, provided in the frame so as to block the opening formed by the frame.
[12] An exposure original plate comprising a mask and a pellicle according to [11] above fitted onto the mask.
[13] An exposure device comprising:
   a light source that emits EUV light, and
   an exposure original plate according to [12] above, which is irradiated with the EUV light.

### [ADVANTAGEOUS EFFECTS OF INVENTION]

According to the invention it is possible to provide a pellicle film that tends to have a uniform in-plane thickness, and that therefore easily exhibits uniform transmittance for EUV light. According to the invention it is also possible to provide a pellicle, an exposure original plate and an exposure device which have such a pellicle film.

### BRIEF DESCRIPTION OF DRAWINGS

Fig. 1 is a schematic diagram showing an example of the construction of an exposure device and an exposure original plate according to this embodiment.
Fig. 2 is a schematic diagram showing an example of the construction of a pellicle of the embodiment.
Fig. 3 is a schematic diagram and SEM photograph showing an example of the construction of a bundle according to the embodiment.
Fig. 4 is a TEM photograph showing an example of the construction of a bundle according to the embodiment.
Fig. 5 is a TEM photograph showing a method of measuring the long diameter (t1) and short diameter (t2) of a bundle for the examples.

### DESCRIPTION OF EMBODIMENTS

Embodiments of the invention (hereunder referred to simply as "embodiments") will be described below with reference to the accompanying drawings. Throughout the following description, the upper limits and lower limits for each numerical range may be combined as desired, or they may be replaced with the values mentioned in the Examples. Moreover, the numerical ranges represented using "to" include the numerical values before and after "to", unless otherwise specified. The term "step", as used herein, refers not only to an independent step, but also includes any function added to a step, even if it cannot be clearly distinguished from another step. The scales, forms and lengths for each of the members shown in the drawings are exaggerated for clarity.

### Embodiment 1

### [Exposure device and exposure original plate]

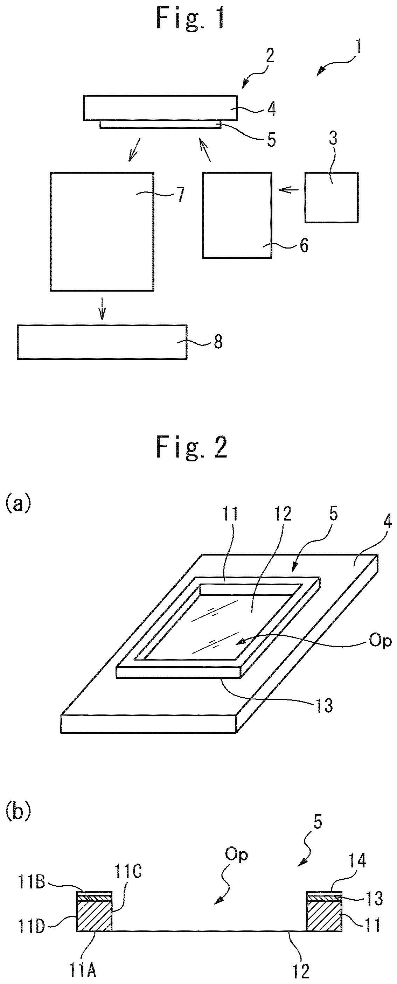

Fig. 1 is a schematic diagram showing an example of the construction of an exposure device 1 and an exposure original plate 2 according to the embodiment. The exposure device 1 comprises a light source 3 that emits EUV light, and an exposure original plate 2 which is irradiated with EUV light. The exposure original plate 2 includes a mask 4 and a pellicle 5 fitted onto the mask 4. The exposure device 1 further includes an illumination optical system 6, a projection optical system 7 and a stage 8.

The exposure device 1 is a reflector-type apparatus, which is an apparatus suitable for EUV lithography. In the exposure device 1, EUV light emitted from the light source 3 is collected by the illumination optical system 6 and irradiated onto the mask 4 through the pellicle 5. The EUV light reflected by the mask 4 again passes through the pellicle 5, and is guided to a photoresist (not shown) on the stage 8 by the projection optical system 7.

The pellicle 5 is used in the exposure device 1 and the exposure original plate 2. Even after hydrogen radicals have been generated by irradiation with EUV light, therefore, deterioration of the pellicle film by the hydrogen radicals can be satisfactorily reduced. This allows the properties required for the pellicle film (such as heat resistance and high transparency for EUV light) to be maintained for prolonged periods. The exposure device 1 and exposure original plate 2 can therefore satisfactorily meet demands for micronization of patterns.

### [Pellicle]

### [General construction]

Fig. 2(a) and (b) are schematic diagrams showing examples for the construction of the pellicle 5 for this embodiment. The pellicle 5 includes a frame 11 and a pellicle film 12 provided in the frame 11 so as to block the opening Op formed by the frame 11. The pellicle 5 is fitted onto the mask 4 so as to cover a circuit pattern (not shown) drawn on the mask 4.

The thickness of the pellicle film 12 is preferably 10 to 200 nm, more preferably 10 to 100 nm and even more preferably 10 to 50 nm, from the viewpoint of suitability for EUV lithography.

### [Frame]

The frame 11 includes a pair of long sides and a pair of short sides, with the rectangular opening Op being formed by the long sides and short sides. Since the long sides and short sides are both essentially cuboid, the frame 11 has four sides (the one end face 11A, the other end face 11B on the side opposite the one end face 11A, the inner peripheral surface 1C and the outer peripheral surface 1D on the side opposite the inner peripheral surface 1C). The pellicle film 12 is provided on the one end face 11A of the frame 11. The one end face 11A and the pellicle film 12 are shown to be in direct contact in the drawing. However, another member (for example, an adhesive layer) may be situated between the one end face 11A and the pellicle film 12, within a range that does not adversely affect EUV lithography.

The area of the opening Op may be appropriately set from the viewpoint of suitability for EUV lithography. If the area of the opening Op is small it will be easier to prevent deformation of the pellicle film 12, and if the opening Op is large it will be easier to enclose the circuit pattern drawn in the mask 4.

The frame 11 is composed of a material including titanium, a β-type titanium alloy or a carbon material, for example. A titanium alloy is preferred, with a β-type titanium alloy being more preferred. This will help to impart flexibility to the frame 11, thus helping to reduce distortion of the mask 4 when the pellicle 5 is fitted onto the mask 4. The frame 11 will also tend to have high strength.

### [Mask pressure-sensitive adhesive layer and release film]

The frame 11 may include an adhesive layer (mask adhesive layer) for attachment of the frame 11 to the mask 5. In the diagram, the frame 11 is shown to include a mask adhesive layer 13 on the side opposite the side on which the pellicle film 12 is formed (the one end face 11A) (in other words, on the other end face 11B). The mask adhesive layer 13 is composed of an adhesive such as an acrylic, rubber, vinyl, epoxy or silicone, for example. Acrylic or silicone-based adhesives are preferred among these. The thickness of the mask adhesive layer 13 may be 0.1 to 1.0 mm, for example.

When the pellicle 5 includes a mask adhesive layer 13, it may further include a release film 14 (liner) laminated on the adhesive side of the mask adhesive layer 13. The release film 14 reduces deterioration in the pressure-sensitive adhesive force of the mask adhesive layer 13 during storage or transport of the pellicle 5. When the pellicle 5 is fitted onto the mask 4, the release film 14 can be released from the mask adhesive layer 13, thereby allowing the adhesive side of the mask adhesive layer 13 to be exposed.

The thickness of the release film 14 may be 30 to 200 µm, for example, and it may be composed of a resin such as polyester, for example. In order to improve the release property, the surface of the release film 14 may be subjected to release treatment (for example, treatment with a silicone layer or fluorine layer).

### [Pellicle film]

### [General construction]

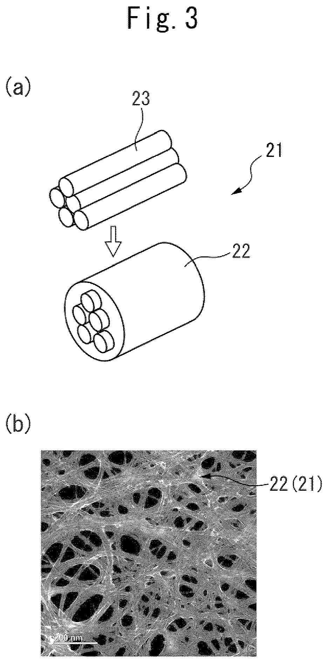

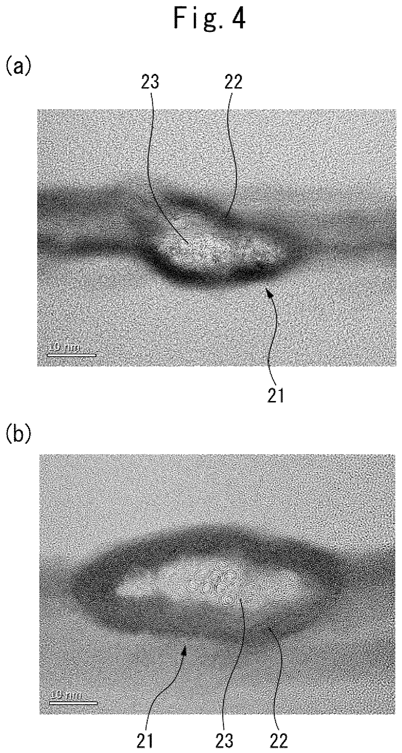

Fig. 3(a) and (b) and Fig. 4(a) and (b) are diagrams showing examples of the construction of the bundle 21 composing the pellicle film 12. Fig. 3(a) is a perspective view schematically showing an example of the construction of a bundle 21, as a mode in which the inorganic material layer 22 is disposed around the bundle 21 which includes multiple CNTs 23. Fig. 3(b) is an SEM photograph showing an example of the mesh structure formed by the bundle 21, and Fig. 4(a) and (b) are TEM photographs showing examples of the cross-sectional structure of the bundle 21.

One aspect of this embodiment is a pellicle film 12 to be used for EUV lithography, wherein the pellicle film 12 has a bundle 21 containing multiple CNTs 23, the bundle 21 including an inorganic material layer 22 containing an inorganic oxide and/or an inorganic nitride (see Fig. 3(a), for example).

Even when hydrogen radicals have been generated by irradiation with EUV light, the pellicle film 12 satisfactorily reduces deterioration of the CNTs 23 by the hydrogen radicals. This will allow the properties required for the pellicle film 12 (such as heat resistance and high permeability for EUV light) to be maintained for prolonged periods, and will help to provide a pellicle film with high transmittance and uniformity of high transmittance.

### [Use of EUV lithography]

EUV lithography is lithography using EUV light as the exposure light, and it is carried out using an exposure device 1, for example. In EUV lithography, EUV light, which is a shorter wavelength than conventional exposure light, is irradiated onto the pellicle film 12 under a hydrogen atmosphere, for example. The pellicle film 12 has an EUV light transmittance of preferably 90% or greater, more preferably 93% or greater and even more preferably 95% or greater. This will allow EUV lithography to be carried out more easily.

### [Bundle]

### (CNT)

The bundle 21 is a bundle containing a plurality of CNTs 23, for example. The outer peripheral surfaces of the CNTs 23 disposed on the outermost side of the bundle are connected to form the outer peripheral surface of the bundle 21. The CNTs 23 forming the bundle 21 may be:
CNTs having a monolayer structure (single-wall nanotubes; SWCNT),
CNTs having a two-layer structure (double-wall nanotubes; DWCNT), or
CNTs having a multilayer structure with three or more layers (multi-wall nanotubes; MWCNT). If the number of layers in the layered structure is low, it will be easier to reduce the thickness of the pellicle film 12.

The length of the CNTs 23 is preferably less than 10 µm. Including relatively short CNTs 23 will increase the number of ends of the CNTs 23 in the pellicle film 12. In this case, it is possible to satisfactorily obtain a mode in which the ends of the CNTs 23 are wrapped around other CNTs 23, thereby helping to improve the film strength of the pellicle film 12. The CNTs preferably have a carbon purity of 99.5% or higher. This will help to reduce adverse effects by impurities, thus helping to improve transmittance for EUV light.

### (Mesh structure)

Each bundle 21 extends in a predetermined direction, the plurality of bundles 21 forming a mesh structure in the pellicle film 12. Gaps are formed in the mesh in Fig. 3(b). In Fig. 3(b), the portions represented in white correspond to the bundles 21 and inorganic material layer 22, and the portions represented in black correspond to the gaps between the bundles 21.

### (Inorganic material layer)

The inorganic material layer 22 is provided so as to cover the outer peripheral surface of the bundle 21. The inorganic material layer 22 acts as a suitable barrier for the CNTs 23 further inside the inorganic material layer 22. Therefore, the pellicle film 12 preferably has an inorganic material layer 22 on the outermost periphery of the bundle 21. This will satisfactorily help prevent deterioration of the CNTs 23 by hydrogen radicals.

The inorganic material layer 22 may be disposed on the outermost periphery of the bundle 21 in contact with the outermost periphery, or it may be disposed via any other layer, or it may be disposed across a predetermined gap. The inorganic material layer 22 may consist of a single layer or multiple layers. The inorganic material layer 22 can be easily formed by exposing the inorganic material on the outer peripheral surface of the bundle 21, for atomic layer deposition

### (ALD).

The inorganic material layer 22 may have a monolayer structure or a multilayer structure of two or more layers. A monolayer structure will help to lower the density of the mesh structure. If a multilayer structure of two or more layers is used, on the other hand, the function of each layer will be exhibited and it will be easier to obtain an inorganic material layer 22 with excellent properties. A multilayer structure with two or more layers can be obtained, for example, by applying different inorganic materials for ALD.

### (Refractive index)

The ratio (ni/nc) between the refractive index (ni) of the inorganic material layer 22 at an exposure wavelength of 13.5 nm and the refractive index (nc) of the CNTs 23 at an exposure wavelength of 13.5 nm, is preferably 0.95 to 1.05. This will make possible a mode wherein the refractive index of the inorganic material for EUV light is near the refractive index of the CNTs 23 for EUV light, in which case it will be possible to satisfactorily inhibit scattering of EUV light in the inorganic material layer 22, thus helping to achieve high permeability for EUV light.

### (Extinction coefficient)

The extinction coefficient (ki) of the inorganic material layer 22 at an exposure wavelength of 13.5 nm is preferably 0.05 or lower. This can satisfactorily inhibit EUV light energy from being absorbed into the inorganic material, thus helping to achieve resistance against degradation by EUV light.

### (Inorganic material)

The inorganic material layer 22 includes an inorganic oxide and/or an inorganic nitride. Such an inorganic material layer 22 acts as a barrier to shield the interior CNTs 23 from hydrogen radicals that can be generated by irradiation with EUV light. This then makes it possible to retain the properties required for the pellicle film 12 (such as heat resistance and transmission for EUV light) for prolonged periods. Since these inorganic materials have greater resistance against degradation by EUV light than CNTs 23, the bundle 21 is more suitably shielded from EUV light. This will therefore also help to provide resistance to degradation by EUV light.

The inorganic material is preferably a material that includes at least one oxide and/or nitride selected from the group consisting of zirconium (Zr), niobium (Nb), aluminum (Al), hafnium (Hf), lanthanum (La), molybdenum (Mo), silicon (Si), yttrium (Y) and titanium (Ti). This will help to provide both resistance to degradation by EUV light and high transmission of EUV light. Such materials also facilitate surface treatment using publicly known thin-film forming techniques. A thin-film forming technique used here may be, for example, the atomic layer deposition method (ALD).

Examples of preferred inorganic materials include the following.
Zirconium oxide (ZrO₂), zirconium nitride (ZrN and/or Zr₃N₄),
niobium oxide (Nb₂O₅), niobium nitride (NbN),
aluminum oxide (Al₂O₃), aluminum nitride (AlN),
hafnium oxide (HfO₂), hafnium nitride (HfN),
lanthanum oxide (La₂O₃), lanthanum nitride (LaN),
molybdenum oxide (MoO₃), molybdenum nitride (MoN),
silicon oxide (SiO₂), silicon nitride (SiN),
yttrium oxide (Y₂O₃), yttrium nitride (YN)
titanium oxide (TiO₂), titanium nitride (TiN)

Since ALD is a method of alternately reacting an organometallic material gas with an oxidizing gas or reactive nitrogen gas, the inorganic material is preferably a metal oxide or nitride from the viewpoint of satisfactorily achieving ALD. The inorganic material is preferably an oxide or nitride from the viewpoint of resistance to hydrogen radicals generated by irradiation of EUV light under a hydrogen atmosphere.

From the viewpoint of the refractive index, the inorganic material layer 22 is preferably zinc oxide, zirconium oxide, yttrium oxide, niobium oxide or molybdenum oxide.

From the viewpoint of the extinction coefficient, the inorganic material of the inorganic material layer 22 is preferably lanthanum oxide, niobium oxide, silicon oxide, yttrium oxide or zirconium oxide.

The inorganic material used may be of one or more types. The inorganic material may also include an inorganic material other than the materials mentioned above (another inorganic material). The other inorganic material does not need to be an oxide or nitride. Such other inorganic materials include ruthenium (Ru) and platinum (Pt). The amount of the other inorganic material may be 10 mass% or lower, 5 mass% or lower, 1 mass% or lower or 0 mass%, with respect to the total amount of the inorganic material. The amount of the other inorganic material may also be 10 mass% or lower, 5 mass% or lower, 1 mass% or lower or 0 mass%, with respect to the total amount of the inorganic material.

### (Cross-section)

A predetermined cross-section is obtained by cutting the bundle 21 on the plane crossing with the direction of extension of the CNTs 23 (see Fig. 4(a) and (b), for example). This includes the aforementioned bundle 21 wherein the flatness ratio {(t1 - t2)/t1} calculated from the long diameter (t1) and short diameter (t2) of the bundle 21 is 0.10 to 0.90. The properties required for the pellicle film 12 (such as heat resistance and high transmission for EUV light) can therefore be easily maintained for prolonged periods.

The long diameter (t1) and short diameter (t2) are the long diameter and short diameter derived mathematically, assuming the bundle to have an elliptical cut surface. The long diameter (t1) and short diameter (t2) are perpendicular at the intersection P. The long diameter (t1) and short diameter (t2) are measured based on the methods described in the Examples.

The lower limit for the flatness ratio is preferably 0.20 or greater, more preferably 0.35 or greater, even more preferably 0.45 or greater and most preferably 0.60 or greater. The upper limit for the flatness ratio is preferably 0.90 or lower, more preferably 0.85 or lower and most preferably 0.80 or lower. A high degree of flatness ratio means that the degree of flatness of the cross-section is high, and for this embodiment, most (for example, 80% or greater) of the bundles obtained by image observation have elliptical shapes where the long diameter (t1) runs along the in-plane direction of the pellicle film 12 and the short diameter (t2) runs along the thickness direction of the pellicle film 12. Such a shape tends to result in a uniform in-plane thickness, thus helping to achieve uniformity of transmittance.

The long diameter (t1) and short diameter (t2) can be adjusted by the coating conditions for the CNT dispersion during the step of fabricating the pellicle film 12, the drying conditions for the coating film containing the CNT dispersion, and the degree of tension on the pellicle film 12. In order to obtain a bundle 11 with high flatness ratio (the cross-sectional shape being elliptical), it is preferred to select the type and amount of dispersing agent in the wet process, for example.

When the bundle 21 has been cut on the plane crossing with the direction of extension of the CNTs 23, the long diameter (t1) of the bundle 21 is preferably 5.0 to 40.0 nm, and the lower limit for the long diameter (t1) is preferably 10.0 nm or greater, more preferably 13.0 nm or greater, even more preferably 15.0 nm or greater and most preferably 20.0 nm or greater. The upper limit for the long diameter (t1) is preferably 40.0 nm or smaller, more preferably 35.0 nm or smaller, even more preferably 30.0 nm or smaller and most preferably 28.0 nm or smaller. The short diameter (t2) is preferably 2.0 to 20.0 nm, and the lower limit for the short diameter (t2) is preferably 2.0 nm or greater, more preferably 5.0 nm or greater, even more preferably 6.0 nm or greater and most preferably 8.0 nm or greater. The upper limit for the short diameter (t2) is preferably 20.0 nm or smaller, more preferably 18.0 nm or smaller, even more preferably 16.0 nm or smaller and most preferably 14.0 nm or smaller. This will facilitate the effect of the invention and help ensure strength of the mesh structure, while also facilitating thinning of the pellicle film.

The inorganic material layer 22 preferably surrounds the entire bundle 21 when the bundle 21 has been cut on the plane that intersects with the direction of extension of the CNTs 23. This will help to provide a barrier of the inorganic material layer 22 over the entire circumferential direction of the bundle 21. From the same viewpoint, according to one aspect, the inorganic material layer 22 preferably surrounds the entire bundle 21, at least on the cut surface that has been cut on the plane that crosses the direction of extension of the bundle 21.

When the bundle 21 has been cut on the plane that intersects with the direction of extension of the CNTs 23, the cross-section preferably includes the inorganic material layer 22 where the inorganic material layer 22 has a thickness of 0.5 to 8.0 nm. The thickness is more preferably 0.5 to 5.0 nm, and especially 1.0 to 3.5 nm. This will facilitate the effect of the invention and help to ensure strength of the mesh structure, while also facilitating thinning of the pellicle film. The thickness of the inorganic material layer 22 corresponds to the thickness of the sections that can function as the inorganic material layer 22, and for example, it can be analyzed by an image obtained using a transmission electron microscope (TEM).

### [Method for producing pellicle film]

Film formation processes for CNT films include wet processes and dry processes. The term "wet process" refers to a process utilizing a CNT dispersion, and "dry process" refers to a process that does not utilize a dispersion. An example of a wet process will now be explained.

According to one aspect, the method for producing a pellicle film includes
a step of coating a dispersion containing CNTs onto a substrate to form a coating film (step 1),
a step of drying the coating film to form a CNT-containing film on the substrate (step 2),
a step of immersing the top of the substrate on which the CNT-containing film has been formed in water, and recovering the CNT-containing film (step 3),
a step of heating the CNT-containing film (step 4), and
a step of surface treatment of the CNT-containing film to situate the inorganic material layer 22 on the bundle 21 containing the multiple CNTs (step 5).

### (Step 1)

In step 1, a dispersion containing CNTs is coated onto a substrate to form a coating film. The dispersion containing the CNTs can be prepared by dispersing CNTs synthesized by a prescribed method in a solution of the dispersing agent in a solvent. The solvent is preferably a solvent with a surface tension of 50.00 mN/m or greater, more preferably a solvent with a surface tension of 60.00 mN/m or greater and even more preferably a solvent with a surface tension of 70.00 mN/m or greater. The specific solvent is preferably an aqueous solution {a solution containing water and a solvent other than water (another solvent)}, or water (surface tension: 72.75 mN/m), with water being especially preferred. It is believed that the surface tension of the solvent of the dispersion containing CNTs contributes to the flatness ratio of the bundle, and specifically, it is thought that during drying of the coating film described below, stress is generated due to the surface tension of the solvent, thus tending to increase the flatness ratio of the bundle. When the solvent is an aqueous solution containing water and another solvent, the water content in the aqueous solution is preferably 50 vol% or higher, more preferably 70 vol% or higher, even more preferably 80 vol% or higher and most preferably 90 vol% or higher. Dispersing agents include sodium dodecylsulfate, flavin derivatives, sodium cholate and sodium dodecylbenzenesulfonate.

The substrate used may be a glass panel or the like.

The method of coating the dispersion containing the CNTs may be spin coating, with the rotational speed for spin coating usually being 300 rpm or greater, preferably 600 rpm or greater and more preferably 1000 rpm or greater. The rotation time for spin coating may usually be 3 seconds or longer, preferably 5 seconds or longer and more preferably 15 seconds or longer.

### (Step 2)

In step 2, the coating film obtained in step 1 is dried to form a CNT-containing film on the substrate. The drying may be carried out using a thermal processing furnace in a nitrogen atmosphere, for example. The drying temperature may be 800 to 1400°C, 900 to 1300°C or 1000 to 1200°C, for example.

### (Step 3)

In step 3, the substrate that has passed through step 2 (the substrate with the CNT-containing film formed on it) is immersed in water, and the CNT-containing film is recovered. The recovery may be accomplished using a predetermined frame to scoop up the CNT-containing film from the water.

### (Step 4)

In step 4, the CNT-containing film recovered in step 3 is heated. This may be carried out using a vacuum furnace under reduced pressure or with a vacuum atmosphere, for example. The drying temperature may be 200 to 600°C, 300 to 500°C or 350 to 450°C, for example. When a dispersion containing a dispersing agent is used in step S1, the dispersing agent often remains in the CNT-containing film that is recovered in this step, but heating during the step can reduce the amount of dispersing agent.

### (Step 5)

In step 5, the inorganic material layer 22 is disposed on the bundle 21 by surface treatment of the CNT-containing film (that is, the outer periphery of the bundle of the film) after step 4. The surface treatment may be, for example, a method of exposing the inorganic starting material to the outer peripheral surface of the bundle 21 using atomic layer deposition (ALD). The type of inorganic material and the thickness of the inorganic material can be controlled by adjusting the type of inorganic material used in ALD and the accumulation volume by ALD.

### [Method for producing pellicle]

The pellicle may be obtained by a common method using the pellicle film 12 described above.

Specifically, this includes:
a step of preparing the pellicle film 12 (step 11), and
a step of attaching the prepared pellicle film 12 to the frame 11 so as to block the opening Op formed by the frame 11 (step 12).

In addition,
a step of forming a mask adhesive layer 13 and release film 14 on the frame 11, and
a step of forming a filter in the open holes of the frame 11,
may be carried out after step 11 and step 12, or between step 11 and step 12, as necessary.

### Other embodiments

The invention is not limited to the aforementioned embodiments 1 and 2, and various modifications may be implemented within the scope of the gist thereof.

The frame may have any desired outer shape and inner shape for attachment of the pellicle film, and for surrounding the circuit pattern drawn on the mask 4. The frame is integrally constructed, but it may also be constructed in a separatable manner.

The pellicle film may be contact bonded to the frame, or the pellicle film may be attached to the frame via a predetermined pressure-sensitive adhesive layer (film adhesive layer). The pellicle 11 may include a predetermined pressure-sensitive adhesive layer on the inner peripheral surface 11C of the frame. The pellicle 11 may have mechanical means such as a jig for mounting the pellicle 11 on the mask 4, in which case the mask adhesive layer 13 and release film 14 can be omitted.

### EXAMPLES

The present embodiment will now be explained in greater detail using Examples and Comparative Examples.

### [Method for producing pellicle film]

### [Example 1]

After adding 1 g of CNTs and 1 g of sodium dodecylsulfate as a dispersing agent to 500 mL of water, the mixture was stirred with a magnetic stirrer at a rotational speed of 300 rpm for 1.5 hours to obtain a suspension. The suspension was then dispersed by treatment with ultrasonic waves for 2 hours. During the treatment, the suspension was sufficiently cooled with water so that the liquid temperature did not exceed 30°C. A CNT dispersion was thus obtained. The obtained CNT dispersion was degassed to obtain a degassed dispersion.

The obtained dispersion was spin coated onto a glass substrate (rotational speed: 1200 rpm, 15 seconds), and dried. A CNT film with a thickness of 80 nm was thus obtained on the glass substrate. The glass substrate was immersed in water to release the CNT film from the glass substrate, and the CNT film was scooped up with a frame to obtain a CNT self-supporting film.

The obtained CNT self-supporting film was heated in a vacuum furnace at 400°C to reduce the amount of sodium dodecylsulfate. Next, silicon dioxide (SiO₂) was exposed to the CNT self-supporting film, by ALD. A pellicle film for Example 1 was thus obtained.

### [Example 2] to [Example 7]

Pellicle films were obtained by the same method as Example 1, except that the starting materials and physical properties were changed as shown in the table. ALD was not carried out in Example 7.

### [Comparative Example 1]

A pellicle film was obtained by the same method as Example 1, except that ZEONANO^{R} 03DS-NP-RD (0.3% N-methyl methylpyrrolidone dispersion of ZEONANO^{R} SG101 by Zeon Corp.) was used as the CNT dispersion. The surface tension of N-methylpyrrolidone was 41 mN/m.

### [Method for producing pellicle]

Each of the pellicle films of the Examples and Comparative Examples was thermocompression bonded onto one end face of a Ti frame, while an acrylic mask adhesive layer was provided on the other end face, to fabricate a pellicle. It was also possible to satisfactorily obtain an exposure original plate and an exposure device for each of the pellicles of the Examples, by a common method.

The Ti frame used was a frame with outer dimensions of 40 mm × 35 mm, inner dimensions of 30 mm × 25 mm, and a height of 3 mm.

### [Evaluation of properties]

### [EUV transmittance]

The EUV transmittance was measured by irradiation with EUV light at a wavelength of 13.5 nm, using a New Subaru BL-10 (of the University of Hyogo). The beam size was 1.0 mm × 0.06 mm. The transmittance was evaluated as "G" for 90% or higher and "P" for lower than 90%.

### [Transmittance uniformity]

The method described under [EUV transmittance] was used for scanning of the center section of the sample in the short side direction. The difference between the section with the highest transmittance and the section with the lowest transmittance was evaluated as "G" for less than 0.8%, "F" for 0.8 to 1.2%, and "P" for greater than 1.2%.

### [Scattering]

EUV light with a wavelength of 13.5 nm was irradiated onto a New Subaru BL-10 (of the University of Hyogo), and thus the scattered light obtained by it was received as a CCD image and analyzed. The scattered light was calculated as scattered light within ±6°. The scattered light was evaluated as "G" for less than 0.4%, and "P" for 0.4% or greater.

### [EUV hydrogen resistance]

This was carried out with a New Subaru BL-9 (of the University of Hyogo). The sample was set in a chamber and subjected to vacuum suction, after which hydrogen was introduced at 20 Pa, and EUV light with a wavelength of 13.5 nm was irradiated with an intensity of 14 W/cm² and a cumulative dose of 140 kJ/cm².

After the irradiation test, the sample was visually examined and evaluated as "G" if the film shape could be maintained without wrinkles, "F" if wrinkles were present, and "P" if damaged.

### [Long diameter (t1) and short diameter (t2) of bundle]

The pellicle films of the Examples and Comparative Examples were each attached to a silicon dummy substrate and then processed by FIB to fabricate a cross-sectional observation sample. The prepared sample was observed under a JEM-F200 transmission electron microscope (TEM) by JEOL. The acceleration voltage was 200 kV. In the image obtained by TEM, the inorganic material sections produce darker photographed sections, and therefore the darker colored sections were considered to be the inorganic material layer. When the inorganic material layer boundary was indistinct, the image was binarized with image processing software to clarify the boundary lines.

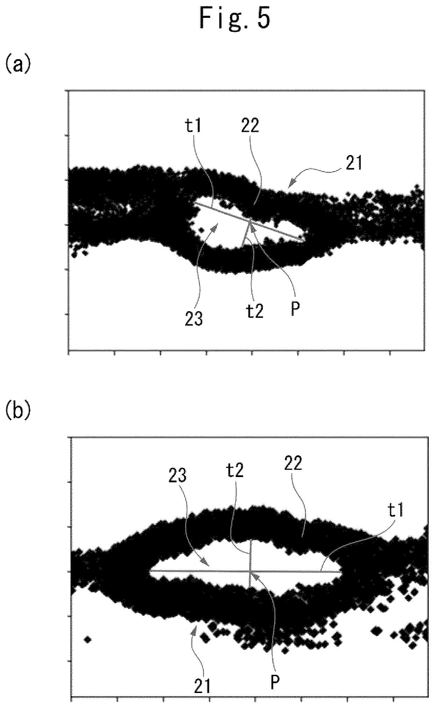

Figs. 5(a) and (b) are TEM photographs showing a method of measuring the long diameter (t1) and short diameter (t2) of the bundle 21 in the cross sections of Figs. 4(a) and (b). In Fig. 5, the cross-sectional image is binarized, the inorganic material layer 22 appearing as black, and the inner CNTs 23 appearing as white. The longest straight line transversing the bundle 21 from boundary to boundary was considered to be the long axis, and its length was recorded as the long diameter (t1). The vertical bisector of the long axis was drawn into the bundle 21, and the length of that line segment was recorded as the short diameter (t2). The obtained long diameter (t1) and short diameter (t2) were used to calculate the flatness ratio {(t1 - t2)/t1}.

### [Table 1]

**Table 1**

| | CNT | | | | Inorganic material layer | | | | | Evaluated properties | | | |
|---|---|---|---|---|---|---|---|---|---|---|---|---|---|
| | Bundle diameter | | Flatness ratio | Refractive index | Materials | Thickness | Extinction coefficient | Refractive index | Refractive index ratio | EUV **transmittance** | Transmittance uniformity | Scattering | EUV hydrogen resistance |
| | t₁ | t2 | (t₁-t₂)/t₁ | n_{c} | | tᵢ | kᵢ | nᵢ | nᵢ/n_{c} | % | % | % | |
| Example 1 | 23.6 | 6.4 | 0.73 | 0.96 | SiO₂ | 4.3 | 0.011 | 0.978 | 1.019 | G | G | G | G |
| Example 2 | 16.5 | 9 | 0.45 | 0.96 | Nb₂O₅ | 4.1 | 0.014 | 0.950 | 0.989 | G | G | G | G |
| Example 3 | 12 | 9 | 0.25 | 0.96 | ZrO | 3.2 | 0.045 | 0.963 | 1.003 | G | G | G | G |
| Example 4 | 21.4 | 11 | 0.49 | 0.96 | Nb₂O₅ | 2.4 | 0.014 | 0.950 | 0.989 | G | G | G | G |
| Example 5 | 15.2 | 13.2 | 0.13 | 0.96 | SiO₂ | 3.4 | 0.011 | 0.978 | 1.019 | G | F | G | G |
| Example 6 | 22 | 5 | 0.77 | 0.96 | Nb₂O₅ | 0.1 | 0.014 | 0.950 | 0.989 | G | G | G | F |
| Example 7 | 24 | 5 | 0.79 | 0.96 | None | - | - | - | - | G | G | G | P |
| Comp. Ex. 1 | 15 | 15 | 0 | 0.96 | None | - | - | - | - | G | P | G | P |

### INDUSTRIAL APPLICABILITY

The present invention can be utilized in the fields of pellicle films, pellicles, exposure original plates and exposure devices.

### REFERENCE SIGNS LIST

1: Exposure device
2: Exposure original plate
3: Light source
4: Mask
5: Pellicle
6: Illumination optical system
7: Projection optical system
8: Stage
11: Frame
11A: One end face
11B: Other end face
11C: Inner peripheral surface
11D: Outer peripheral surface
12: Pellicle film
21: Bundle
22: Inorganic material layer
23: Carbon nanotubes (CNT)
t1: Long diameter
t2: Short diameter
P: Intersection between long diameter and short diameter

## Claims

1. A pellicle film to be used for EUV lithography, wherein:
the pellicle film has a bundle comprising a plurality of carbon nanotubes (CNT), and
the pellicle film includes the bundle which has a flatness ratio {(t1 - t2)/t1} of 0.10 to 0.90, calculated from the long diameter (t1) and short diameter (t2) of the bundle, when the bundle has been cut on the plane crossing the CNTs in the direction of extension.

2. The pellicle film according to claim 1, wherein the bundle comprises an inorganic material layer containing an inorganic oxide and/or an inorganic nitride.

3. The pellicle film according to claim 2, wherein the pellicle film has the inorganic material layer on the outermost periphery of the bundle.

4. The pellicle film according to claim 2, wherein:
the inorganic material layer surrounds the entire bundle, when the bundle has been cut on the plane crossing the CNTs in the direction of extension.

5. The pellicle film according to claim 2,
which includes the inorganic material layer wherein the thickness of the inorganic material layer is 0.5 to 8.0 nm,
when the bundle has been cut on the plane crossing the CNTs in the direction of extension.

6. The pellicle film according to claim 1 or 2, wherein:
the long diameter (t1) of the bundle is 5.0 to 40.0 nm and the short diameter (t2) is 2.0 to 20.0 nm,
when the bundle has been cut on the plane crossing the CNTs in the direction of extension.

7. The pellicle film according to claim 2, wherein the ratio (ni/nc) between the refractive index (ni) of the inorganic material layer at an exposure wavelength of 13.5 nm and the refractive index (nc) of the CNTs at an exposure wavelength of 13.5 nm is 0.95 to 1.05.

8. The pellicle film according to claim 2, wherein the extinction coefficient (ki) of the inorganic material layer at an exposure wavelength of 13.5 nm is 0.05 or lower.

9. The pellicle film according to claim 2, wherein:
the inorganic material composing the inorganic material layer
which includes at least one oxide and/or nitride selected from the group consisting of zirconium (Zr), niobium (Nb), aluminum (Al), hafnium (Hf), lanthanum (La), molybdenum (Mo), silicon (Si), yttrium (Y) and titanium (Ti).

10. The pellicle film according to claim 1 or 2, wherein the transmittance for EUV light is 90% or greater.

11. A pellicle comprising:
a frame, and
a pellicle film according to claim 1 or 2, provided in the frame so as to block the opening formed by the frame.

12. An exposure original plate comprising a mask and a pellicle according to claim 11 fitted onto the mask.

13. An exposure device comprising:
a light source that emits EUV light, and
an exposure original plate according to claim 12, which is irradiated with the EUV light.
